# EUROPEAN PATENT APPLICATION

(11) **EP 1 067 558 A1**
(43) Date of publication of application: **10.01.2001**
(21) Application number: 99830438.0
(22) Date of filing: 08.07.1999
(51) Int. Cl.: G11C 16/10, G11C 16/26

(54) **Data codification method for the writing of non volatile memory cells**

(71) Applicant: STMicroelectronics S.r.l., 20041 Agrate Brianza (Milano) (IT)
(72) Inventor: Dozza, Davide, 40055 Villanova di Castenaso (BO) (IT); Canegallo, Roberto, 15057 Tortona (AL) (IT); Borgatti, Michele, 41035 Finale Emilia (MO) (IT)
(74) Representative: Mittler, Enrico

(57) **Abstract**

It is described a new method to codify the data for the writing of non volatile memory cells (6) included in a memory array (3). The method provides the following steps succession:
a) data to be memorized are initially sent to a small memory cell matrix (15) which acts as buffer;
b) a control logic (9) regulates the data flow between an input/output circuitry (8) of said memory array (3) and such small memory cells matrix buffer (15) and it provides to send the data to be memorised to a coder / decoder block (18);
c) the codified / decodified information by said coder / decoder block (18) is sent to an elaborator (20) which calculates the distance between two successive data combinations;
d) said control logic (9) indicates to a writing logic (22) the completion of the codification operation of the data to be stored in the memory array (3);
e) said writing logic (22) effects the programming of the memory array (3) cells (6) on the basis of the result of the calculus effectuated by said elaborator (20).

## Description

The present invention refers to a data decodification method for the writing of non volatile memory cells.

The market request for non volatile memories, that is memory cells which maintain their programmation status also in absence of the feeding voltage, with storage capacity bigger and bigger imposes to the semiconductor suppliers a continuous effort in the reduction of the dimension and of the power consumption of the devices and in the increase of recordable data density.

As it is known, in a CMOS system the two main components which contribute to the power dissipation are: 1) the static consumption due to: 1.1) leakage current (called leakage current); 1.2) bias currents; 2) dynamic consumption due to: 2.1) current transients during the switching; 2.2) charging and uncharging of capacitative nodes.

The static contribution in a digital system is generally negligible in respect to the dynamic one.

The power dynamic consumption is given by the following proportionality relation:
Pdiss proportional to f*Vdd²*ΔiAiCi where Ci represents the load capacity of the i-th node summed on N circuit nodes, Vdd is the feeding voltage, f is the circuit working frequency and A is the activity factor to the i-th node (called switching activity), that is the number of the gates which switch in the same time on the total gates which do not switch. The dynamic power consumption dictated by the previous formula refers to transaction of the potential of the capacitative nodes between the ground level and Vdd (power feeding voltage level) and to their following complete discharge. For transaction it is meant the variations of a data from a logic status 0 to a logic status 1 and viceversa. The transitions The transitions are important in the energy consumption and so in the power dissipation because during these ones, capacitative nodes are to be charged and discharged with high voltages and that involves energy dissipation.

In the non volatile memories during reading, writing and erasing operations numerous transitions occur which result determining on the general balance of the dissipated power.

Unfortunately the non volatile memories are not low power consumption systems because of the process implementation of the cell. In fact during the programming and the erasing operations to remove the electric charges present in the floating gate are necessary high electric fields and therefore high potential differences on the gate electrode and therefore it is not easy to realise a non volatile memory of low consumption.

In applications such as the storage of identification codes, the software programming of microprocessor etc, the transitions which occur with the highest frequency are the reading transitions. In other applications such as the mass storage, vocal recorders, digital videocameras etc, the prevailing transitions are the reading ones.

If for the reading transitions the contribute in power dissipation terms can be neglected as the reading operation occurs at lower voltages and however, for electronic instruments such as vocal recorders, digital videocameras etc, the reading operation occurs off-line, for example unloading data on a p.c. hard disk, using the external feeding and not the battery, it results on the contrary of primary importance the power consumption reduction in the reading and erasing operations.

As it is evicted from the formula previously illustrated one of the ways to save power it is to reduce the feeding voltage as this term weights with a quadratic factor on the balance of the power dissipated or to implement reading and writing more efficient algorithms. At the moment the system to reduce the feeding voltage is that to generate internally high voltages through dc-dc converters, that is through circuits called charging pumps.

As it concerns the writing are used algorithms able to reduce the programming current in the single cells.

The non volatile memory flash cells, being small and light, are particularly suitable for portable electronic instruments (such as cellular telephones, portable personal computers, digital cameras, hard disks, etc) and in said instruments to preserve the duration of the batteries it is necessary to optimize the power consumption.

In view of the described prior art the aim of the present invention is that of realising a data codification method which allows to reduce the transaction and therefore the power dissipation in the writing and erasing operations.

According to the present invention that aim is achieved by means of a data codification method for the writing of non volatile memory cells included in a memory array, characterised by the fact to provide the following steps succession:
a) data to be memorized are initially sent to a small memory cell array which acts as buffer,
b) a control logic regulates the data flow between an input/output circuitry of said memory array and between such memory buffer and it provides to send the data to be memorised to a coder / decoder block,
c) the codified / decodified information by said coder / decoder block are sent to an elaborator which calculates the distance between two successive data combinations,
d) said control logic indicates to a writing logic the completion of the codification operation of the data to be stored in the memory array,
e) said writing logic effects the programming of the memory array cells on the basis of the result of the calculus effectuated by said elaborator.

Thanks to the present invention it is so possible to realise a data codification method for the writing and erasing of the non volatile memory cells using technique called of codification of the data line (bus encoding). The characteristics and advantages of the present invention will result evident from the following detailed description of one of its practical embodiment, illustrated as non restrictive example in the enclosed drawings, in which:
the figure 1 shows the necessary hardware for the execution of the method according to the invention;
the figure 2 shows the phases of the method itself;
the figure 3 shows an example of a possible technique of codification on a data line;
the figure 4 shows the obtainable saving transitions with data codification techniques.

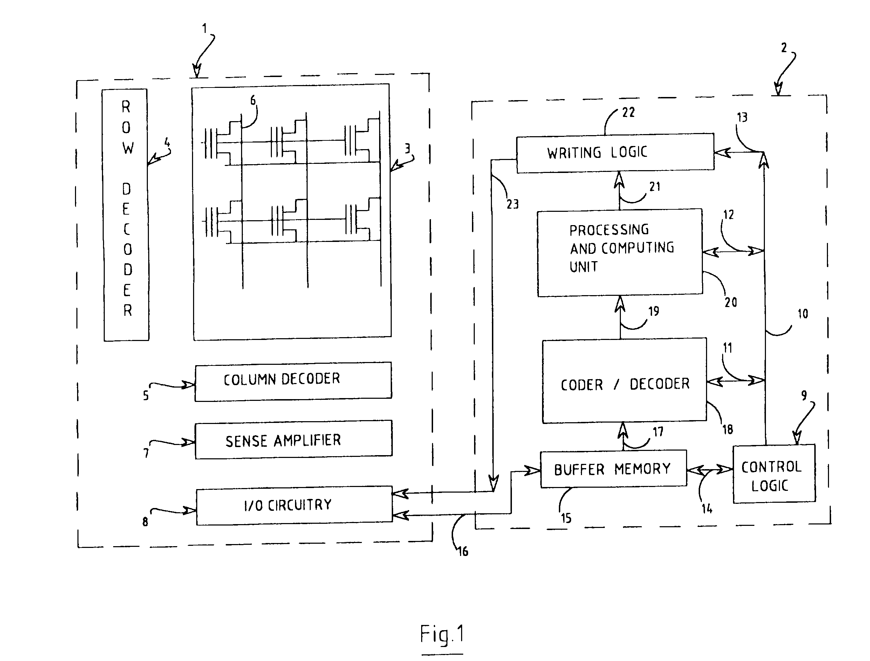

In the figure 1 it is indicated with 1, in its complex, a simplified block scheme able to program the memory, and it is indicated with 2, in its complex, a block scheme of a possible hardware implementation necessary for the execution of the method according to the invention.

According to what illustrated in such a figure note that the block 1 is composed of a memory matrix (array) 3 with cells distributed on row and column, by a row decodifying circuitry 4 and of a column decodifying circuitry 5, both of them external to the matrix 3 necessary to select a particular memory cell 6, internal to said matrix 3. The contents of these cells 6 become available thanks to an additional circuitry, including sense simplifiers 7 and an input/output circuitry 8 so that it is possible to realise the functionality of the memory itself.

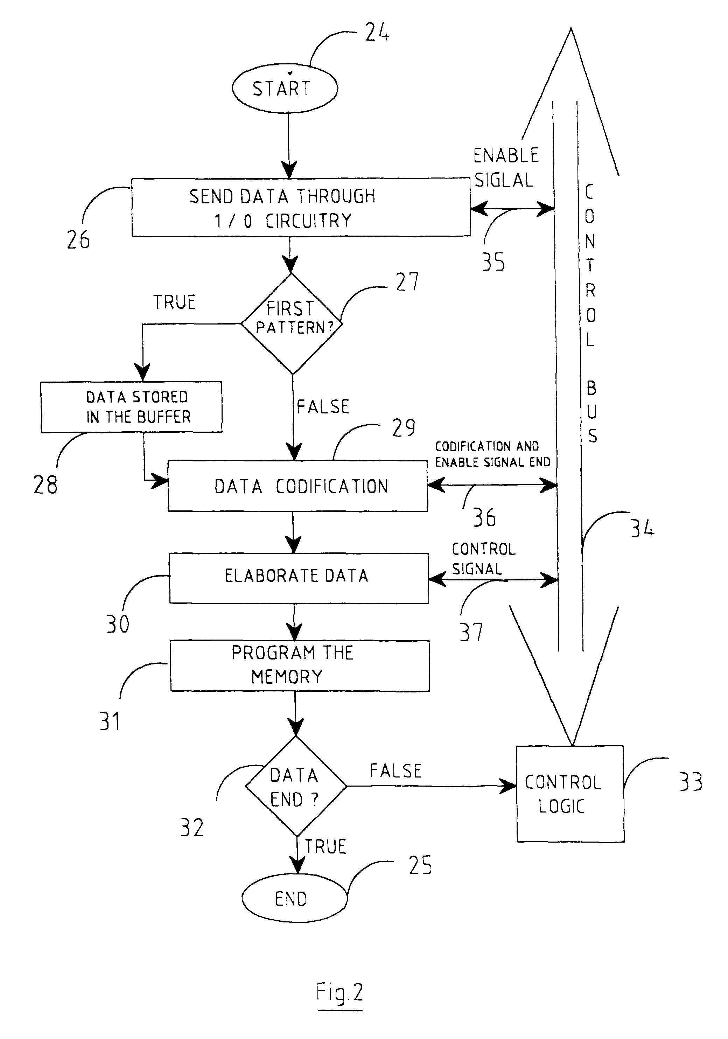

Note besides that the block 2 is composed of an appropriate logic control 9 which superintends the management of all the circuitry present by some dedicated control lines 10, 11, 12, 13, and 14, by a buffer memory 15, obtained or by an array sector 3 or by inserting a small stand alone matrix of cells, connected to the input/output circuit 8 by a line 16 and managed by the block 9, whose information is given by a link 17, to a coder / decoder block 18, managed by the control logic 9 by lines 10 and 11. The block 18 provides the codified/decodified data, by a link 19, to a processing and computing block 20, managed by the control logic 9 by the lines 10 and 12. The data so elaborated are sent, by a line 21, to a logic writing block 22, managed by the block 9 through the lines 10 and 13. Said block 22 is linked through a line 23 to the input/output block 8 in such way that once occurred the operations represented by said blocks 18, 20, 22, as hereafter described in details with references to figure 2, the programming operation of the memory can be performed according to the conventional methods.

Codification devices, elaboration units and the control logic can be implemented either singularly or in an integrated way in the state machine which manages the memory operations, or in the microcontroller, to reduce the area consumption. Further the buffer memory 15 and the coder/decoder 18 can be implemented in an external hardware to the chip of the memory matrix and of the writing and controlling logics.

In figure 2 the steps composing the new method according to the invention are shown.

According to what shown in such a figure note an initial block 24, called " CODIFICATION AND DECODIFICATION ALGORITHM" and a final block 25 called "END".

Initially, block of elaboration 26, called "SEND DATA THROUGH I/O CIRCUIT ", the new information to be memorized within the matrix 3 is sent to a memory 15 which acts as buffer, by means of the circuitry 8.

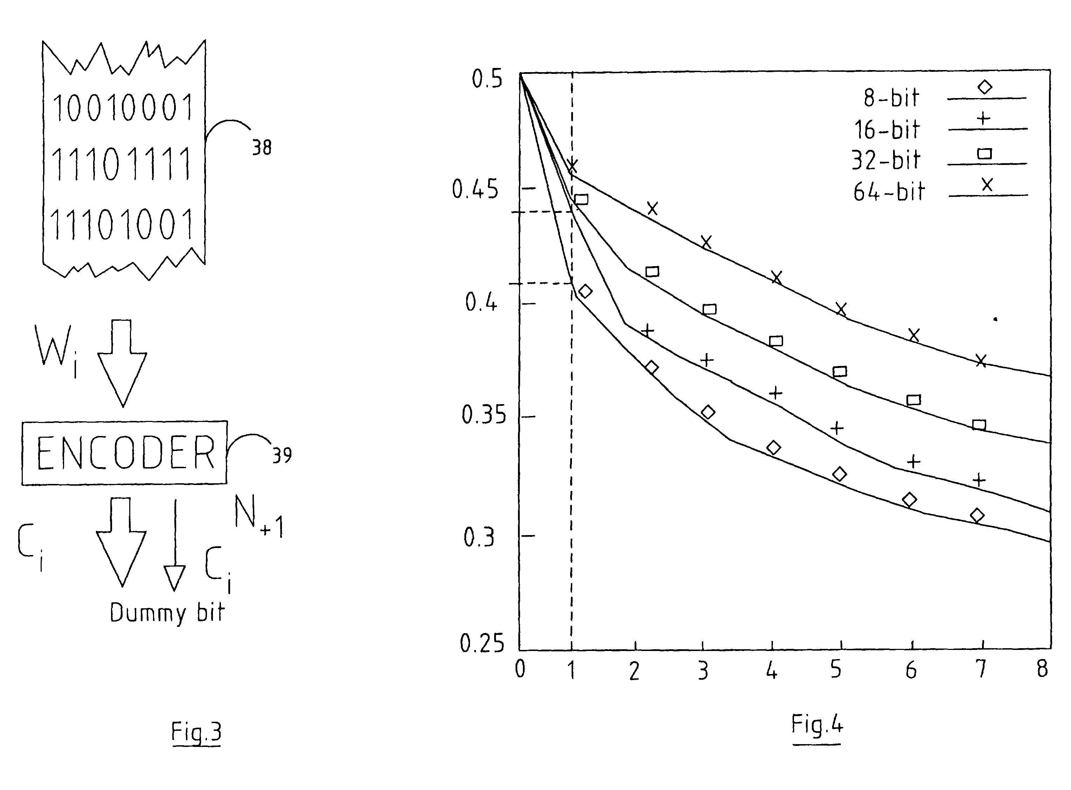

Then, decision block 27, called "FIRST PATTERN", is executed a verification step to decide if it is the first bit sequence in input to matrix 3. In the case in which it is the first bit sequence, output "TRUE" of the elaboration block 27, it is executed the decision block 28, called " MEMORIZED DATA IN THE BUFFER CELLS", that is the new information is memorized in the buffer memory 15 and subsequently said information is codified through the execution of the elaboration block 29, called "DATA CODIFICATION", as hereafter described in details in the figure 3. In the case that there is not the first bit combination, output FALSE of the block 27, said data are codified through the execution of the elaboration block 29.

Said block 29 through a biunique signal line 36 called "Codification and Enable Signal End", through the elaboration block 33 called "CONTROL LOGIC", indicates the occurred codification phase of the bit to said block 33 which provides to regulate the information flow from the input/output circuit 8 to the memory cells 15.

In succession, the elaboration block 30, called "ELABORATE DATA" the codified information is opportunely treated, as later described in details in figure 3, because it is possible to execute the writing operation of the new information in the array 3, function managed by the elaboration block 31, called "PROGRAM THE MEMORY".

Said block 30 through the biunique signal line 37, called "Control Signal", through the elaboration block 33, indicates the occurred phase of elaboration of codified and decodified bits to said block 33 which provides to send the data to write to the block 31.

Therefore, occurred the bits codification and decodification operations, block 29, and of elaboration, block 30, the control unit, block 33, indicates to the block 31 the completion of such an operation and the programming operation of the memory matrix 3 proceeds according to the known technique.

Therefore, decision block 32, called "DATA END", is executed a test phase to determine if the bit sequence sent to the circuitry 8 is over. In the case in which there are no more bits, TRUE output of the block 32, the algorithm ends, block 25. In the case in which the bit flow goes on coming from the block 8, FALSE output of the block 32, through a control logic, elaboration block 33, which manages the arbitrage of the line data 34, called "BUS CONTROL", and through the signal line 35, called "Active Signal", the execution of the algorithm from the block 26 restarts executing again the previously described phases.

Performing the successions of the operations seen before a reduction in the number of writing transitions is obtained and then a power saving is obtained, besides less noise is introduced and then the signal to noise ratio of the memory improves.

In figure 3 it is shown a possible example of data codification technique ("bus encoding").

According to what shown in such a figure note a bit sequence 38 which flows in elaboration block 39, called "ENCODER", which effects the codification of said bits.

For instance it is possible to use the Hamming code which constitutes a special category for the codification of the binary codes and for the correction of the single error.

After the codification operation, block 39, the data are sent to the elaboration unit, block 30, where the distance between two following combinations of writing bits is calculated.

It is defined the distance between two sequences of the binary code the number of bits in which said sequence differs. Indicating with d(x, y) the distance function defined as:
d(x, y) = the distance between x and y
said function satisfies the following conditions:
a) d(x, y) > = 0 and d(x, y) = 0 if and only if x = y (definition of positivity)
b) d(x, y) = d(y, x) (symmetry)
c) d(x, y) < = d(x, y) + d(y, x) (triangular inequality)

For instance d(0, 1) = 1, d(001, 011) = 1, d(000, 111) = 3, d(111,111)= 0.

If such a distance is bigger than N/2, where N represents the length of the bit sequence or the width of the data line, said sequence is written with inverted polarity, otherwise the original polarity is maintained.

An additional bit is used to state which is the bit combination polarity codified, that is a data line is added. The method guarantees a maximum of N/2 transitions for clock cycle and the maximum performances are obtained when the bit sequence to transmit is randomly distributed in the time and it is not available any information about the bit correlation.

In the figure 4 it is shown the medium saving of the number of the ottenable transitions using "dummy" bit.

According to what shown in such a figure note an axis of the abscissa indicating the number of "dummy" bit used for the codification, and an axis of the ordinate indicating the medium number of transition for a data line.

Further note five different series of points indicating the width N of the data line respectively of 8-bit, 16-bit, 32-bit and 64-bit.

From the graphic shown in such a figure it is deducible that a single "dummy" bit for a 8-bit data line reduces of about 18% the medium number of transitions which a data line must execute for an incorrelated bit sequence.

## Claims

1. Data codification method for the writing of non volatile memory cells included in a memory array, characterised by the fact that said codification occurs by the following steps succession:
a) data to be memorized are initially sent to a small memory cell matrix (15) which acts as buffer;
b) a control logic (9) regulates the data flow between an input/output circuitry (8) of said memory array (3) and such small memory cells matrix buffer (15) and it provides to send the data to be memorised to a coder / decoder block (18);
c) the codified / decodified information by said coder / decoder block (18) is sent to an elaborator (20) which calculates the distance between two successive data combinations;
d) said control logic (9) indicates to a writing logic (22) the completion of the codification operation of the data to be stored in the memory array (3);
e) said writing logic (22) effects the programming of the memory array (3) cells (6) on the basis of the result of the calculus effectuated by said elaborator (20).

2. Data codification method for the writing of non volatile memory cells included in a memory array according to the claim 1, characterized by the fact that the cells (6) programmation is executed by codes which allows to reduce the number of the symbols 0 and 1 which requires an high energy level.

3. Data codification method for the writing of non volatile memory cells included in a memory array according to the claim 2, characterized by the fact that said codes are chosen in a way that, called N the length of the data bit sequence to be memorized or the width of the data line used, the sequence is written with inverted polarity or unchanged according to that the calculated distance is smaller or greater than N/2.
